# EUROPEAN PATENT APPLICATION

(11) **EP 1 770 787 A2**
(43) Date of publication of application: **04.04.2007**
(21) Application number: 06020539.0
(22) Date of filing: 29.09.2006
(51) Int. Cl.: H01L 29/78, H01L 29/739, H01L 21/336, H01L 21/331, H01L 29/08

(54) **Semiconductor device with a MOS transistor and method of manufacturing the same**

(30) Priority: 03.10.2005 GB 0520057
(71) Applicant: AMI Semiconductor Belgium BVBA, 9700 Oudenaarde (BE)
(72) Inventor: Hakim, Hedi, 9700 Oudenaarde (BE); Tack, Marnix, 9820 Merelbeke (BE)
(74) Representative: Bird, Ariane

(57) **Abstract**

A semiconductor device, such as a vertical DMOS device, has a gate (10), a source and a drain, an n-type body region (1) a p-type well region (2) a highly doped n-type region (6) in the well region, the well region being adjacent to the body region to form a neck in the body region. The neck has a localized increase in dopant concentration having a local maximum at a depth (4) away from an upper surface of the body. This can help to reduce ON resistance and provide a high breakdown voltage, provided it is at a similar depth as a depth (3) of a maximum dopant concentration of the well region. If the dopant concentration at the upper surface of the body is unaffected by the localized increase, then CMOS devices can be integrated in the same well region.

## Description

### Field of the invention:

This invention relates to electronic device, e.g. semiconductor devices. In particular, the invention relates to MOS devices such as vertical MOS devices and corresponding methods of manufacture.

### Description of the Related Art:

The main contributions to the ON resistance between drain and source of a Vertical DMOS transistor are the drift region, the JFET region, the accumulation region and the channel region. The conventional approach to reducing the ON-resistance in conventional vertical DMOS is to make each cell smaller so that a greater number can be built on a given area of silicon. By increasing the number of transistor cells acting in parallel, one reduces the ON resistance between drain and source. As the cells are made smaller and closer to each other, their interactions are more and more pronounced. For instance, a Junction Field Effect between adjacent cells restricts the vertical current flow and limits the achievable decrease in ON resistance. It is known in the art how to reduce the contribution to the specific ON resistance of the region below the gate without substantial decrease of the breakdown voltage of a Vertical DMOS transistor.

In US 6,894,345 B2, the JFET pinch is reduced by a masked implant through a narrow window. Such a masked implant presents inconveniences like (a) necessity for additional photolithography steps and (b) the minimum feature size of the transistor cells are further constrained by the alignment of the implant mask and the diffusion of implanted impurities. At the same time that the ON resistance is reduced, the breakdown voltage of the DMOS remains unaffected by the implant.

In "Reduction of the On-State Resistance for a 100V Power MOSFET by Shallow-Junction and Blanket Implant Technology" (Kou-Way Tu et al in International Conference on Informatics, Cybernetics and System - ICICS 2003, 12/14-16 pp. 51-54), a blanket implant is used to overcome the increase in RJFET resulting from the decrease in size of the gate and channel length of a POWER MOSFET unit cell while maintaining the breakdown voltage of the MOSFET. The goal of the blanket implant is to increase the n-type carrier concentration at the surface in order to compress the P-body profile (the JFET effect is reduced by reducing the depth of the p-body). While beneficial to the performances of the POWER MOSFET, such a blanket implant that modifies the carrier concentration at the surface of the semiconductor substrate is bound to affect any CMOS transistor that would be integrated on the same substrate as the

POWER MOSFET in a smart power integrated circuit.

In US 6,137,139 an n-type blanket implant is used in conjunction with an n-well that is deeper than the p-well used as p-body for the VDMOS. The combination of the deep n-well and n-type blanket implant results in a more highly doped neck region, hence a lower neck resistance. The blanket implant decreases the neck resistance but it tends to move the device breakdown location upwards (this means lower breakdown voltage and poor reliability of the device). This tendency is counteracted by a tendency toward downward movement promoted by inclusion of the deep n-well. In US 6,137,139 reduction of the contribution of the specific ON resistance of the neck region of the DMOS requires both a blanket implant and a deep n-well that is not necessarily available or desired (since it adds to the complexity of the fabrication process). There remains need for improvement.

### Summary of the Invention:

An object of the invention is to provide improved vertical MOS devices and corresponding methods of manufacture.

According to a first aspect, the invention provides:

A gate controlled electronic device such as a vertical MOS device or an IGBT, having a control electrode such as a gate, a first main electrode such as a source and second main electrode such as a drain, a body region of a first conductivity type, below the control electrode, e.g. gate, a well region of a second conductivity type, the well region having a depth, a highly doped region of the first conductivity type in the well region, the well region being adjacent to the body region to form a neck region in the body region, the neck region being in a current path between the second main electrode, e.g. drain, and the first main electrode, e.g. source, and comprising a region having a localized increase in dopant concentration having a local maximum at a depth away from an upper surface of the body region and less than a depth of the well region, wherein the region comprising the localized increase in dopant concentration is not as deep as the well region.

This can help to reduce ON resistance and provide a high breakdown voltage. Surprisingly, any adverse effect that an anti JFET n-type blanket implant could have on the voltage breakdown disappears if it is done at a depth that does not exceed the depth of the p-well. The highly doped region of the first conductivity type in the well region is doped more highly than the well itself.

An additional feature of some embodiments is the local maximum being at substantially the same depth as a depth of a maximum dopant concentration of the well region. In some embodiments, the dopant concentration at the upper surface of the body region is substantially unaffected by the localized increase. This may mean there is little or no effect on the characteristics of the CMOS transistors that can be co-integrated with the DMOS transistor. In some embodiments, the localized increase is at a depth range of 0.25 µm to around 0.7 µm. The localized increase can have a carrier concentration of 2 to 10 times no where no is the carrier concentration of the rest of the body. The body region of the device can be formed of an epitaxial layer.

The gate controlled electronic device such as the vertical MOS device or the IGBT, can have one or more CMOS transistors integrated on a common substrate.

Another aspect provides a method of manufacturing a gate controlled electronic device such as an IGBT or a vertical MOS device, the method having the steps of forming a body region of a first conductivity type, forming a well region of a second conductivity type in a surface of the body region, next to a neck region of the body region, forming a control electrode insulating layer such as a gate insulator and control electrode such as a gate electrode over the neck region of the body region, adjacent to the well, forming a highly doped region of the first conductivity type in the well region, and creating in the neck region a region having a localized increase in dopant concentration having a local maximum at a depth away from an upper surface of the body region and less than a depth of the well region, wherein creating the region having the localized increase in dopant concentration is performed such that the region is not as deep as the well region.

A feature of some embodiments is the localized increase being created during growth of the body region. Another such feature is the localized increase being created by a blanket implantation step after the body region has been formed. Another such feature is the localized increase being created by a masked implant step after the body region has been formed.

In some embodiments, the local maximum can be at substantially the same depth as a depth of a maximum dopant concentration of the well region. The dopant concentration at the upper surface of the body region can be substantially unaffected by the localized increase. The localized increase can be at a depth range of 0.25 µm to around 0.7 µm.

The localized increase can have a carrier concentration of 2 to 10 times no where no is the carrier concentration of the rest of the body region. In some embodiments, the implantation is carried out before an annealing step for annealing the well region. In some embodiments the implantation uses phosphorus, implanted for example at an energy in the range 400keV to 600keV, or arsenic at an energy of several MeV, and the dose of the implant is between 0.5x10¹² cm⁻² and 2.5x10¹² cm⁻².

Any of the additional features can be combined together and combined with any of the aspects. Other advantages will be apparent to those skilled in the art, especially over other prior art. Numerous variations and modifications can be made without departing from the claims of the present invention. Therefore, it should be clearly understood that the form of the present invention is illustrative only and is not intended to limit the scope of the present invention.

### Brief Description of the Drawings:

How the present invention may be put into effect will now be described by way of example with reference to the appended drawings, in which:
Figure 1 shows a vertical DMOS transistor according to an embodiment of the present invention.
Figure 2 shows a doping profile of the semiconductor substrate as a function of the distance from the surface,
Figure 3 shows a graph of variation of breakdown voltage and specific ON Resistance as a function of a blanket implant dose,
Figure 4 shows a dopant concentration in the substrate after blanket implantation when the dose of the implant is 0.5x10¹² cm⁻², and
Figure 5 shows a dopant concentration in the substrate after blanket implantation when the dose of the implant is 2.0x10¹² cm⁻².
Figure 6 shows a process flow in accordance with an embodiment of the present invention.

### Description of the Preferred Embodiments:

The present invention will be described with respect to particular embodiments and with reference to certain drawings but the invention is not limited thereto but only by the claims. Any reference signs in the claims shall not be construed as limiting the scope of the invention. The drawings described are only schematic and are non-limiting. In the drawings, the size of some of the elements may be exaggerated and not drawn on scale for illustrative purposes.

The terms first, second, third and the like in the description and in the claims, are used for distinguishing between similar elements and not necessarily for describing a sequential or chronological order. It is to be understood that the terms so used are interchangeable under appropriate circumstances and that the embodiments of the invention described herein are capable of operation in other sequences than described or illustrated herein.

Furthermore, the terms top, bottom, over, under and the like in the description and the claims are used for descriptive purposes and not necessarily for describing relative positions. It is to be understood that the terms so used are interchangeable under appropriate circumstances and that the embodiments of the invention described herein are capable of operation in other orientations than described or illustrated herein.

Moreover, it is to be understood that the term "comprising", used in the claims, should not be interpreted as being restricted to the means listed thereafter; it does not exclude other elements or steps. It is thus to be interpreted as specifying the presence of the stated features, integers, steps or components as referred to, but does not preclude the presence or addition of one or more other features, integers, steps or components, or groups thereof. Thus, the scope of the expression "a device comprising means A and B" should not be limited to devices consisting only of components A and B. It means that with respect to the present invention, the only relevant components of the device are A and B. Where an indefinite or definite article is used when referring to a singular noun e.g. "a" or "an", "the", this includes a plural of that noun unless something else is specifically stated.

In particular, in the following description, the conduction types of the blanket, well, body and substrate dopants can each or all be reversed, e.g. N-type for P-type and P-type for N-type.

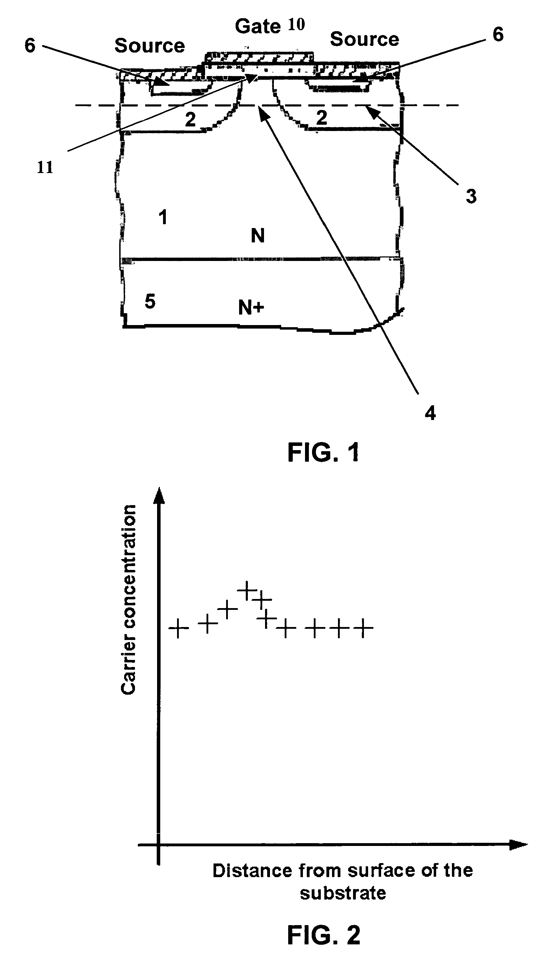

Figure 1 shows a schematic cross section of a gate controlled electronic device such as vertical MOS transistor, e.g. a DMOS according to an embodiment of the invention. The present invention is not limited to MOS transistors. The gate controlled electronic device can be a bipolar transistor such as an IGBT (Insulated Gate Bipolar Transistor). In the following the present invention will be explained mainly in terms of MOS transistors for sake of convenience.

On top of lowly doped semiconductor substrate of a first conductivity type, e.g. p-type (not shown) is a highly doped buried layer 5 of a second conductivity type, e.g. n-type, followed by a body of the device in the form of a moderately doped semiconductor layer 1 of the second conductivity type, i.e. n-type. In the following a silicon substrate will be described. In embodiments of the present invention, the term "substrate" may include any underlying material or materials that may be used, or upon which a device, a circuit or an epitaxial layer may be formed. In other alternative embodiments, this "substrate" may include a semiconductor substrate such as e.g. doped silicon, a gallium arsenide (GaAs), a gallium arsenide phosphide (GaAsP), an indium phosphide (InP), a germanium (Ge), or a silicon germanium (SiGe) substrate. The "substrate" may include for example, an insulating layer such as a SiO₂ or a Si₃N₄ layer in addition to a semiconductor substrate portion. Thus, the term substrate also includes silicon-on-glass, silicon-on sapphire substrates. The term "substrate" is thus used to define generally the elements for layers that underlie a layer or portions of interest. Also, the "substrate" may be any other base on which a layer is formed, for example a glass or metal layer.

Well regions in the form of bodies of the first conductivity type, e.g. p-type bodies (p-bodies) 2 are implanted within the substrate 1 of a second conductivity type, i.e. n-type. Henceforth in this description, reference to p-type is also reference to a first conductivity type and reference to n-type is reference to the second conductivity type. In the appending claims, this convention does not necessarily apply. The p-bodies are optionally also the p-wells used for other MOS transistors, e.g. CMOS transistors that will be co-integrated with the DMOS transistors (this may simplify the fabrication process flow). A gate oxide 11 and a gate electrode 10 are grown, and highly doped n-type regions 6 are implanted in the p-bodies to act as first main electrodes, e.g. sources, for the DMOS. Highly doped means that the doping is higher than in the p-well itself. Then contacts are formed for a first main electrode such as a source and for a control electrode such as a gate contact to form source and gate electrodes. The buried layer 5 that collects the current flowing through the DMOS is contacted in a manner known to the art: an n-type sinker (not shown) extends from the buried layer 5 to the surface of the semiconductor substrate (the same surface that accommodates the source of the DMOS transistor as well as the CMOS transistors) and a second main electrode of the transistor, e.g. a drain contact (not shown) is added. Henceforth, the term source will refer to a first main electrode and the term drain to a second main electrode of a MOS transistor. In the appending claims, this convention does not necessarily apply.

In a first preferred embodiment, a blanket implant is applied to the semiconductor substrate 1 at a depth 4 that is substantially the same as the depth 3 where the core dose of the p bodies 2 has been implanted. The resulting higher n-type carrier concentration in the substrate region between the p-bodies 2 can decrease the efficiency of the parasitic junction field effect transistor and so result in a lower RON resistance. In order not to reduce the breakdown voltage of the transistors, the blanket implant preferably does not go deeper than the p-body regions 2 and it preferably has a lower depth than the p bodies 2. Hence, in other words, the peak concentration of the blanket implant is preferably not deeper than the peak concentration of the p-body regions. The energy for the blanket implant can be substantially the same energy at which the n-wells of the standard CMOS transistors are implanted, e.g. the blanket implant is done with phosphorous at energies in the range 400 keV to 600 keV. The dopant could be any other n-type dopant known in the art like arsenic or antimony. The implant energy should be adjusted appropriately for the dopant.

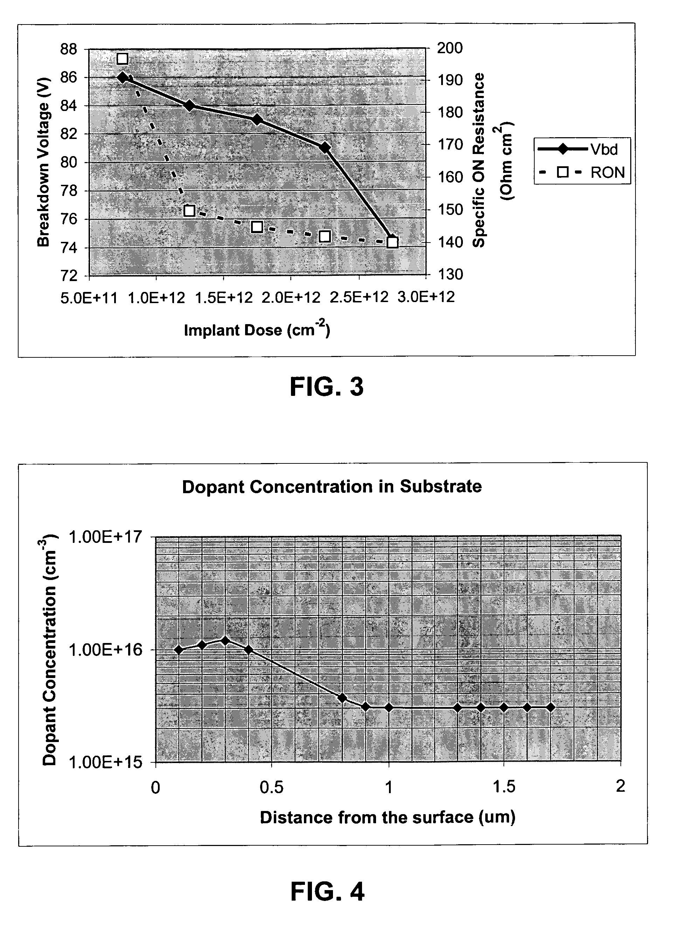

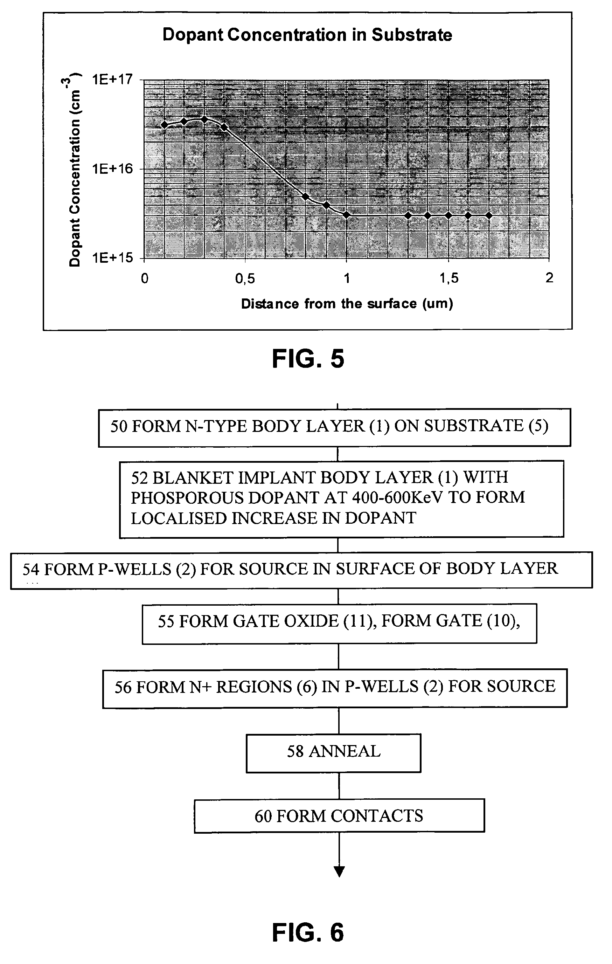

As shown in fig. 3, which relates to an implant energy of 500 keV in a n-type silicon substrate 1 with an n-type carrier concentration no before implantation equal to 3x10¹⁵ cm⁻³, both the ON resistance and the breakdown voltage of the DMOS transistor will vary with the dose of the blanket implant. A dose exceeding 2x10¹² cm⁻² causes a sharp drop in breakdown voltage. The specific ON resistance will decrease as well with increasing implanted doses. The decrease of ON resistance will be very sharp at first then will plateau as the dose exceeds 1.5x10¹² cm⁻². In particular, a dose of 1.25x10¹² cm⁻² results in a substantial decrease of ON resistance and hardly any decrease of breakdown voltage. The value of no is chosen as a function of the desired voltage breakdown for the Vertical DMOS and the value of the implanted dose is chosen such that the n-type carrier concentration of the substrate at the depth of the implant will vary between 2xn₀ to 10xn₀. Fig. 4 shows the doping profile for the n-type silicon substrate 1 after implantation for a dose of 0.5x10¹² cm⁻² with no equal to 3x10¹⁵ cm⁻³. Figure 5 shows the same after implantation for a dose of 2x10¹² cm⁻².

Fig 6 shows some of the principal steps in a method of manufacture. At step 50, the n-type body is formed on a substrate. At step 52, a blanket implant is carried out on the body, to create the localised increase in dopant concentration. At step 54, the p-wells are formed, followed by step 55 when the gate oxide is formed over the neck, and the gate electrode is formed over the gate oxide. The n+ regions for the source are implanted in step 56. At step 58 the device is annealed. Then at step 60 the electrode contacts are formed.

In a second preferred embodiment, the doping of the semiconductor substrate 1 around the depth 4 where the JFET effect affects the DMOS is tuned during the epitaxial growth. The doping can be varied continuously during growth or in a stepwise manner. The preferred carrier concentration of the substrate 1 varies from no deep in the substrate to 2 to 4 times as much at the depth 4 where the JFET pinch must be reduced. The value of no will depend on the desired breakdown voltage for the vertical DMOS transistor, e.g. for a breakdown voltage of 160V, the value of no will be close to 2x10¹⁵ cm⁻³ and for a breakdown voltage of 30V, the value of no will be close to 2x10¹⁶ cm⁻³.

The anti Junction Field Effect blanket implant is preferentially performed just after the LOCOS growth and before implantation of the standard n-well and p-well. In that way, it will get the same thermal annealing as those n- and p-wells. Alternatively, the anti Junction Field Effect implant is implanted after the wells are implanted but before the n-well annealing.

When modulating the concentration of dopant during the epitaxial growth of the substrate 1, the parameters may be tuned continuously or in a stepwise manner. In the latter case, the concentration of dopant (e.g. the dopant could be arsenic), will be increased from no to as high as 25xn₀ when growing the part of the substrate 1 that will be at the depth 4 considered in the above, before being brought back to no when growing the top part of the n-type substrate. The subsequent thermal budget is used to diffuse the impurities to achieve a less abrupt distribution of impurities in the substrate 1.

As has been described, embodiments of the present invention provide an improved smart gate controlled electronic power device, such as a vertical DMOS transistor or an IGBT, with low ON resistance and high breakdown voltage and improved methods to build such transistors without, e.g. affecting the CMOS transistors integrated in the same semiconductor substrate as the DMOS or IGBT. In US 6,137,139 a decrease in the neck resistance is sought, and the adverse effects that an n-type blanket implant has on the breakdown voltage are mitigated by a deep n-well enclosing the p-body. Surprisingly, any adverse effect that the anti JFET n-type blanket implant could have on the voltage breakdown disappears if it is done at a depth that does not exceed the depth of the p-body. Even more surprisingly, restricting the region of the semiconductor substrate where the blanket implant will increase the concentration of n-type carriers to a depth range that more or less matches the depth range at which the core dose of the p-bodies are implanted will reduce the specific ON resistance of the transistor without substantially affecting the breakdown voltage of the DMOS and in addition, it will leave the dopant concentrations at the surface of the semiconductor substrate unaffected, and so will not affect the characteristics of the CMOS transistors that one may want to cointegrate with the DMOS transistor.

A gate controlled electronic device, e.g. a vertical DMOS transistor or IGBT, has been described, where the doping profile of the substrate below the gate presents a local maximum close to the surface of the substrate as exemplified by fig. 2. In the case of an n type vertical DMOS transistor some embodiments have an increase of the substrate doping close to the surface at a depth range and at a dosage that are compatible with both any CMOS transistors (i.e. that will not sensibly affect the performances of the CMOS transistors integrated in the same substrate as the DMOS) and the required breakdown voltage for the DMOS.

In particular embodiments, the depth at which the doping of the substrate is increased is the same depth as the core dose of the p-body of the DMOS or IGBT is implanted. In particular embodiments, the increase of doping of the substrate is done with an implant at the energy required to have the core of the implant at the same depth as the core dose of the p-body. In particular embodiments the energy of the implant is the same as used to implant the n-well of the CMOS transistors integrated in the same substrate as the DMOS or IGBT.

In particular embodiments, the energy of the implant is such that the core dose will be implanted at a depth where the core dose of the p-body implant is e.g. from around 0.25 µm to around 0.7 µm. In particular embodiments, the energy of the implant is such that the core dose will be implanted at a depth of 0.3 µm, or a depth of 0.4 µm.

In particular embodiments, the energy of the implant is in the range 400keV to 600 keV but this depends upon the dopant used. For example, in particular embodiments, the implant is done with phosphorus, and the dose is chosen to decrease the ON resistance of the DMOS or IGBT that is associated with the JFET effect without affecting the breakdown voltage. The dose of the implant is such that the n-type carrier concentration of the n-type substrate at the depth considered here above is 2 to 10 times no where no is the carrier concentration of the n-type semiconductor substrate before implantation, where no is equal to 3x10¹⁵ cm⁻³, or 2x10¹⁵ cm⁻³, or 2x10¹⁶ cm⁻³, and the dose of the implant is comprised between 0.5x10¹² cm⁻² and 2.5x10¹² cm⁻².

In particular embodiments, the implant is a blanket implant, or a masked implant that restricts the implantation to those regions of the semiconductor substrate where the Junction Field Effect pinch must be reduced. The increase of doping of the substrate close to the surface can be done during growth of the epitaxial layer in which the DMOS (or IGBT) and CMOS transistors are integrated. The concentration of dopant in the epitaxial layer can be varied continuously during growth of the epitaxial layer, or the concentration of dopant in the epitaxial layer can be varied in a stepwise manner during growth of the epitaxial layer. The concentration of dopant in the epitaxial layer can be increased at the same depth where the core dose of the p-body implant is, e.g. from around 0.25 µm to around 0.7 µm. In particular embodiments, the concentration of dopant in the epitaxial layer is increased at a depth of 0.3 µm. or at a depth of 0.4 µm.

The concentration of dopant at that depth can be raised from no (carrier concentration of the n-type semiconductor substrate) to any value between 2xn₀ and 10xn₀, particularly to 2x no or 4x no or 10 x no , and no can be equal to 3x10¹⁵ cm⁻³, 2x10¹⁵ cm⁻³, or 2x10¹⁶ cm⁻³ and the dopant can be arsenic.

Other variations can be conceived within the scope of the claims.

## Claims

1. A gate controlled electronic device having a control electrode (10), a first main electrode and a second main electrode, a body region (1) of a first conductivity type, below the control electrode (10), a well region (2) of a second conductivity type, the well region (2) having a depth, a highly doped region (6) of the first conductivity type in the well region (2), the well region (2) being adjacent to the body region (1) to form a neck region in the body region (1), the neck region being in a current path between the second and the first main electrodes, and comprising a region having a localized increase in dopant concentration having a local maximum at a depth (4) away from an upper surface of the body region (1) and less than a depth of the well region (2),
**characterized in that** the region comprising the localized increase in dopant concentration is not as deep as the well region (2).

2. The gate controlled electronic device of claim 1, the local maximum being at substantially the same depth as a depth (3) of a maximum dopant concentration of the well region (2).

3. The gate controlled electronic device of claim 1 or 2, the dopant concentration at the upper surface of the body region (1) being substantially unaffected by the localized increase.

4. The gate controlled electronic device of any preceding claim, the localized increase being at a depth range of 0.25 µm to around 0.7 µm.

5. The gate controlled electronic device of any preceding claim, the localized increase having a carrier concentration of 2 to 10 times no where no is the carrier concentration of the rest of the body.

6. The gate controlled electronic of any preceding claim, the body region (1) being formed of an epitaxial layer.

7. The gate controlled electronic device of any preceding claim, having one or more CMOS transistors integrated on a common substrate.

8. The gate controlled electronic device according to any previous claim, wherein the first main electrode is a source electrode and the second main electrode is a drain electrode and the control electrode is a gate electrode.

9. The gate controlled electronic device according to any previous claim being a vertical DMOS or an IGBT transistor.

10. A method of manufacturing a gate controlled electronic having the steps of forming a body region (1) of a first conductivity type, forming a well region (2) of a second conductivity type in a surface of the body region (1), next to a neck region of the body region (1), forming a control electrode insulator and a control electrode over the neck region of the body region (1), adjacent to the well, forming a highly doped region (6) of the first conductivity type in the well region (2), and creating in the neck region a region having a localized increase in dopant concentration having a local maximum at a depth (4) away from an upper surface of the body region (1) and less than a depth of the well region (2),
**characterized in that** creating the region having the localized increase in dopant concentration is performed such that the region is not as deep as the well region (2).

11. The method of claim 10, the localized increase being created during growth of the body region (1).

12. The method of claim 10, the localized increase being created by a blanket implantation step after the body region (1) has been formed.

13. The method of claim 10, the localized increase being created by a masked implant step after the body region (1) has been formed.

14. The method of any of claims 10 to 13, the local maximum being at substantially the same depth as a depth (3) of a maximum dopant concentration of the well region (2).

15. The method of any of claims 10 to 14, the dopant concentration at the upper surface of the body region (1) being substantially unaffected by the localized increase.

16. The method of any of claims 10 to 15, the localized increase being at a depth range of 0.25 µm to around 0.7 µm.

17. The method of any of claims 10 to 16, the localized increase having a carrier concentration of 2 to 10 times no where no is the carrier concentration of the rest of the body region (1).

18. The method of any of claims 10 to 17 when dependent on claim 12 or 13, the implantation being carried out before an annealing step for annealing the well region (2).

19. The method of any of claims 10 to 18 when dependent on claim 12 or 13, the implantation using phosphorus or Arsenic and the dose of the implant is between 0.5x10¹² cm⁻² and 2.5x10¹² cm⁻².
